# Europäisches Patentamt
# European Patent Office
# Office européen des brevets

(11) Veröffentlichungsnummer : **0 154 668**
**B1**

(12) **EUROPÄISCHE PATENTSCHRIFT**

(45) Veröffentlichungstag der Patentschrift :
15.03.89

(51) Int. Cl.⁴ : **G 12 B 11/02**

(21) Anmeldenummer : **84108196.1**

(22) Anmeldetag : **12.07.84**

(54) Anordnung für eine Skalenbeleuchtung.

(30) Priorität : 08.03.84 DE 8407039 U

(43) Veröffentlichungstag der Anmeldung :
18.09.85 Patentblatt 85/38

(45) Bekanntmachung des Hinweises auf die Patenterteilung : 15.03.89 Patentblatt 89/11

(84) Benannte Vertragsstaaten :
AT BE CH DE FR GB IT LI LU NL SE

(56) Entgegenhaltungen :
DE--A-- 2 215 897
US--A-- 3 718 814
US--A-- 3 800 153

(73) Patentinhaber : **Diemer & Fastenrath**
**Worthstrasse 16**
**D-5880 Lüdenscheid (DE)**

(72) Erfinder : **Möller, Ulrich**
**Grenzweg 11**
**D-5880 Lüdenscheid (DE)**
Erfinder : **Fastenrath, Heinz, Dipl.-Ing.**
**Annabergstrasse 45**
**D-5880 Lüdenscheid (DE)**

(74) Vertreter : **Dörner, Lothar, Dipl.-Ing.**
**Stresemannstrasse 15**
**D-5800 Hagen (DE)**

## Beschreibung

Die Erfindung bezieht sich auf eine Vorrichtung für eine Skalenbeleuchtung mit einer stellenweise beschrifteten Deckfolie und mit einem hinter der Deckfolie angeordneten Lichtleiter, der an den beschrifteten Stellen aktiviert ist.

Solche Beleuchtungseinrichtungen sind beispielsweise in US-A-3'718'814 und US-A-3'800'135 beschrieben.

Bei Autoradios ist ein sog. Nachtdesign bekannt, worunter folgendes zu verstehen ist : In einer Blende sind Kanäle vorgesehen, in die ein konfektionierter Lichtleiter eingelegt ist. Die Kanäle sind mittels einer stellenweise beschrifteten Deckfolie verschlossen, die in die Blende eingeklebt ist. Die aktivierten, das sind die leuchtenden, Stellen des Lichtleiters sind jeweils hinter den beschrifteten Stellen der Deckfolie angeordnet. Die Blende weist einen Durchbruch auf, durch den der Lichtleiter hinter die Blende geführt und dort über eine Einkopplungsstelle mit einer Lichtquelle verbunden ist. Die bekannten Anordnungen weisen folgende Nachteile auf : Um zu verhindern, daß die Deckfolie, jedenfalls stellenweise, einfällt, muß sie relativ dick ausgeführt werden. Der Kleber an der Deckfolie muß durchleuchtet werden. Schließlich hinterleuchtet der in den relativ großen Kanal eingelassene Lichtleiter nicht nur nach Art eines Punktstrahlers die beschriftete Stelle, sondern auch die Umgebung. Den Lichtleiter mit einem Reflektor zu versehen, hilft wegen dessen schmaler Ausführung nur wenig. Zusammengefaßt ist die Helligkeit, mit der die Beschriftungen auf der Deckfolie erscheinen, unnötig gemindert. Hinzu kommt, daß der Bereich um die Kanäle wenig Platz für Klebestellen läßt, was die Haftung der Deckfolie erschwert.

Schließlich sollen bei gleichbleibendem Raum für den Einbau des Autoradios von ihm immer mehr Funktionen ausgeführt werden, was die Einbringung zusätzlicher Teile zur Voraussetzung hat und die Forderung nach sich zieht, daß jedes Teil nur den geringstmöglichen Platz einnehmen darf. Ähnliche Probleme, insbesondere Platzprobleme, treten bei anderen Skalenbeleuchtungen auf, z. B. bei solchen für Elektrogeräte oder Armaturen.

Hier will die Erfindung Abhilfe schaffen. Die Erfindung, wie sie in den Ansprüchen gekennzeichnet ist, löst — ausgehend von den bei Autoradios ausführlich geschilderten Verhältnissen — allgemein die Aufgabe, eine platzsparende, einfach aufgebaute, größere Helligkeit für die beschrifteten Teile ergebende und leicht zu montierende Anordnung für eine Skalenbeleuchtung zu schaffen.

Die Vorrichtung nach der Erfindung wird auf einen Skalenträger aufgeklebt. Irgendwelche Kanäle sind in dem Träger nicht notwendig ; allenfalls eine Aussparung in der Fläche und der Dicke der Anordnung, um zu den Rändern des Trägers hin einen mechanischen Schutz zu erreichen. Die Deckfolie kann dünn gehalten werden, da sie mechanisch von der Distanzfolie gehalten ist. Deckfolie und Distanzfolie bestehen in Ausgestaltung der Erfindung aus demselben Material, insbesondere Polycarbonat, um denselben Ausdehnungskoeffizienten zu gewährleisten. Trägt die Distanzfolie den Kleber für die Verbindung mit der Deckfolie, befindet sich an den von dem Lichtleiter eingenommenen Stellen in der Distanzfolie kein Kleber, der durchleuchtet werden muß. Die Helligkeit, mit der die beschrifteten Stellen in der Deckfolie erscheinen, wird größer. Die Helligkeit ist noch weiter zu verbessern, wenn in Ausgestaltung der Erfindung die Distanzfolie — und nicht nur der Lichtleiter — mit einem Reflektor hinterlegt ist. Die Klebefläche, die für die Verbindung der einzelnen Folien vorhanden ist, ist relativ groß. Die Anordnung ist in ihrem Aufbau einfach und leicht zu montieren. Das wird besonders erkennbar, wenn in weiterer Ausgestaltung der Erfindung die Deckfolie, die Distanzfolie und der Reflektor abgesehen von den Durchbrüchen für die Aufnahme des Lichtleiters, deckungsgleiche Durchbrüche für den Durchtritt von Bedienungselementen aufweisen.

Ein Ausführungsbeispiel der Erfindung in der Form einer Anordnung für die Gerätebeleuchtung eines Autoradios ist in der Zeichnung dargestellt und wird im folgenden näher beschrieben. Es zeigen in schematischer Darstellung :

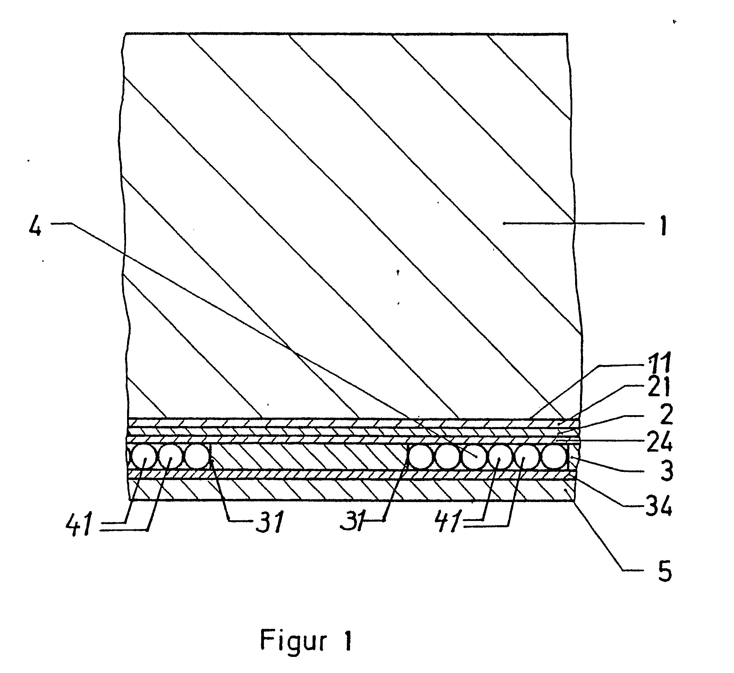

Fig. 1 in vergrößertem Maßstab einen Querschnitt durch einen Teil einer Blende eines Autoradios mit der erfindungsgemässen Vorrichtung ;

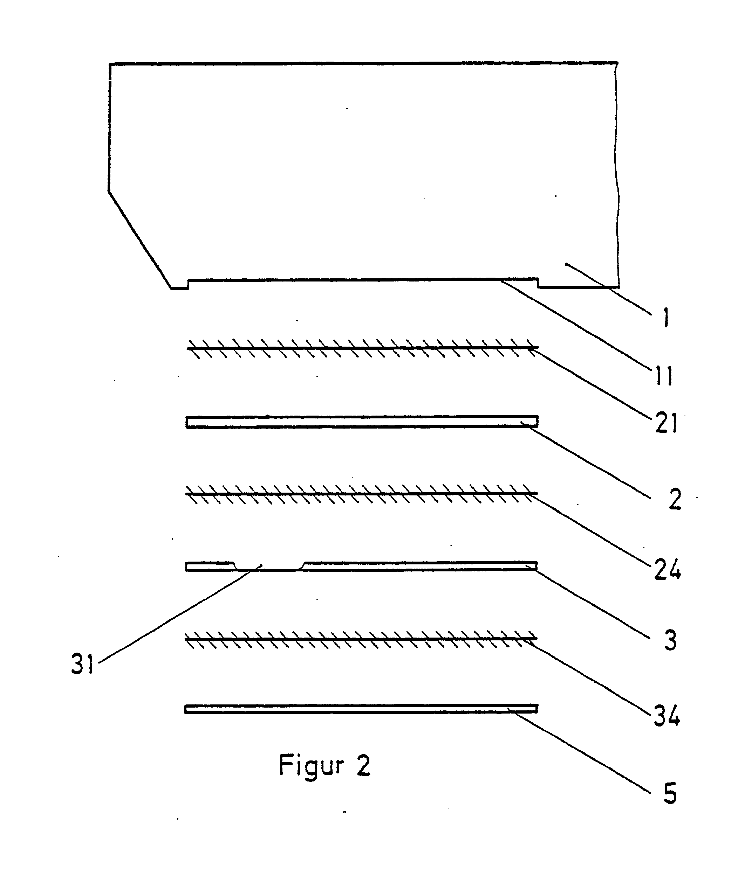

Fig. 2 die in Fig. 1 dargestellte Anordnung in verkleinerter gesprengter Ansicht ;

Fig. 3 die Draufsicht der Distanzfolie, die in der erfindungsgemässen Vorrichtung verwendet ist ;

Fig. 4 die Draufsicht der Deckfolie und des Reflektors, die in der erfindungsgemässen Vorrichtung verwendet sind.

Die als Ausführungsbeispiel gewählte Anordnung für die Gerätebeleuchtung eines Autoradios besteht — von einer Blende 1 aus gesehen von innen nach außen — aus einem Reflektor 2, einer Distanzfolie 3, in die ein Lichtleiter 4 integriert ist, und einer Deckfolie 5.

Die Anordnung 2 bis 5 ist auf die Blende 1 aufgeklebt. Der Reflektor 2 weist zu diesem Zweck auf der der Blende 1 zugewandten Seite einen Kleber 21 auf. Es ist zweckmäßig, in der Blende 1 eine Ausnehmung 11 für die Aufnahme der Anordnung 2 bis 5 vorzusehen, deren Fläche und Tiefe gleich der Fläche und der Dicke der Anordnung sind. In der Ausnehmung 11 weist die Blende 1 einen nicht dargestellten Durchbruch auf, durch den der Lichtleiter 4 hinter die Blende geführt und dort über eine Einkopplungsstelle mit einer Lichtquelle verbunden ist. In der Ausnehmung 11 sind außerdem nicht dargestellte Durchbrüche für den Durchtritt von Bedienungselementen für das Autoradio vorgesehen.

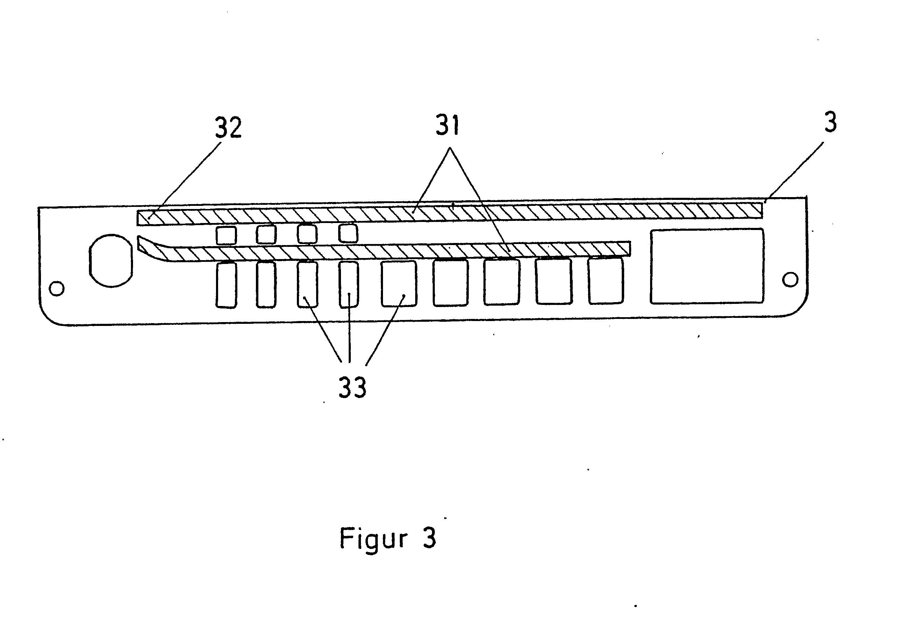

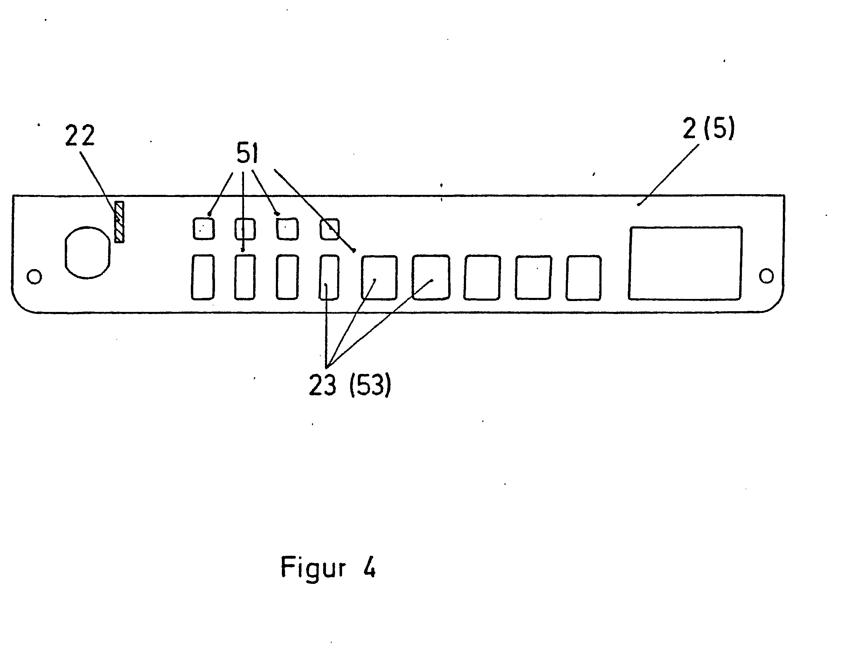

Der Reflektor 2 hat die gleiche länglich rechteckige Form wie die Ausnehmung 11. Kongruent zu den Durchbrüchen in der Blende 1 weist er einen Durchbruch 22 für den Lichtleiter 4 sowie Durchbrüche 23 für die Bedienungselemente auf. — In den Fig. 3 und 4 sind die für den Lichtleiter 4 vorgesehenen Durchbrüche schraffiert dargestellt —. Der Reflektor 2 besteht aus weißem Polyester. Seine Stärke beträgt im Ausführungsbeispiel 0,1 mm.

Vor den Reflektor 2 ist die Distanzfolie 3 geklebt. Zu diesem Zweck weist der Reflektor 2 auf der der Distanzfolie 3 zugewandten Seite einen weiteren Kleber 24 auf. Die Distanzfolie 3 weist kongruent zu den Durchbrüchen 22, 23 in dem Reflektor 2 einen Durchbruch 32 für den Lichtleiter sowie Durchbrüche 33 für den Durchtritt von Bedienungselementen auf. In die Distanzfolie 3 ist der Lichtleiter 4 integriert. Zu diesem Zweck sind in der Distanzfolie 3 lineare Durchbrüche 31 vorgesehen. In die linearen Durchbrüche 31 ist der Lichtleiter 4 mit seinen einzelnen Strängen 41 eingelegt. Die Dicke jedes der parallel zueinander angeordneten Stränge 41 ist gleich der Dicke der Distanzfolie 3. Letztere beträgt im Ausführungsbeispiel ca. 0,3 mm. Bei dem Lichtleiter handelt es sich um ein bekanntes Endlosgarn auf der Basis von Methylmethacrylat mit Polyäthylenbeschichtung. Vor seinem Einsatz in die Anordnung wird der Lichtleiter konfektioniert, insbesondere an den Stellen, an denen die Deckfolie 5 hinterleuchtet werden muß, aktiviert. Die Distanzfolie besteht aus Polycarbonat.

Vor die Distanzfolie 3 ist die Deckfolie 5 geklebt. Zu diesem Zweck weist die Distanzfolie auf der der Deckfolie 5 zugewandten Seite einen Kleber 34 auf. Die äußere Form der Deckfolie 5 ist gleich der des Reflektors 2, abgesehen von dem Durchbruch 22 für den Lichtleiter 4. Oberhalb der Durchbrüche 53 für den Durchtritt der Bedienungselemente weist die Deckfolie 5 Beschriftungen 51 auf, von denen jeweils eine einem der Bedienungselemente zugeordnet ist. Die Beschriftung 51 befindet sich in Höhe der linearen Durchbrüche 31 in der Distanzfolie. Die Deckfolie 5 besteht aus Polycarbonat. Sie weist eine Stärke von 0,25 mm auf.

**Patentansprüche**

1. Vorrichtung für eine Skalenbeleuchtung mit einer stellenweise beschrifteten Deckfolie (5) und mit einem hinter der Deckfolie (5) angeordneten Lichtleiter (4), der an den beschrifteten Stellen aktiviert ist, dadurch gekennzeichnet, daß der Lichtleiter (4) in eine Distanzfolie (3) integriert ist, die hinter der Deckfolie (5) angeordnet ist.

2. Vorrichtung nach Anspruch 1, dadurch gekennzeichnet, daß die Distanzfolie (3) lineare Durchbrüche (31) aufweist, in die der Lichtleiter (4) eingelegt ist.

3. Vorrichtung nach Anspruch 2, dadurch gekennzeichnet, daß die Dicke der Distanzfolie (3) gleich der Dicke des Lichtleiters (4) ist.

4. Vorrichtung nach einem der Ansprüche 1 bis 3, dadurch gekennzeichnet, daß die Distanzfolie (3) und die Deckfolie (5) aus demselben Material bestehen.

5. Vorrichtung nach einem der Ansprüche 1 bis 4, dadurch gekennzeichnet, daß die Distanzfolie (3) auf der der Deckfolie (5) abgewandten Seite mit einem Reflektor (2) hinterlegt ist.

6. Vorrichtung nach einem der Ansprüche 2 bis 5, dadurch gekennzeichnet, daß die Deckfolie (5), die Distanzfolie (3) und der Reflektor (2) abgesehen von den Durchbrüchen (22 ; 31, 32) für die Aufnahme des Lichtleiters (4) deckungsgleiche Durchbrüche (23 ; 33 ; 53) für den Durchtritt von Bedienungselementen aufweisen.

**Claims**

1. A device for illumination of a scale, having a covering foil (5) inscribed in places and having a photoconductor (4) which is arranged behind the covering foil (5) and activated at the inscribed places, characterized in that the photoconductor (4) is integrated into a spacer-foil (3) which is arranged behind the covering foil (5).

2. A device as in Claim 1, characterized in that the spacer-foil (3) exhibits linear openings (31) into which the photoconductor (4) is inserted.

3. A device as in Claim 2, characterized in that the thickness of the spacer-foil (3) is equal to the thickness of the photoconductor (4).

4. A device as in one of the Claims 1 to 3, characterized in that the spacer-foil (3) and the covering foil (5) consist of the same material.

5. A device as in one of the Claims 1 to 4, characterized in that the spacer-foil (3) on the side remote from the covering foil (5) is backed by a reflector (2).

6. A device as in one of the Claims 2 to 5, characterized in that the covering foil (5), the spacer-foil (3) and the reflector (2) exhibit, apart from the openings (22 ; 31, 32) for the reception of the photoconductor (4) congruent openings (23 ; 33 ; 53) for the passage of operating elements.

**Revendications**

1. Dispositif pour un éclairage de cadran, comprenant un film protecteur (5) muni de repères et un guide de lumière (4), activé sur ces repères et disposé derrière le film (5), caractérisé en ce que le guide de lumière (4) est intégré à un film intercalaire (3), disposé derrière le film protecteur (5).

2. Dispositif suivant la revendication 1, caractérisé en ce que le film intercalaire (3) présente des ouvertures linéaires (31), dans lesquelles est inséré le guide de lumière (4).

3. Dispositif suivant la revendication 2, caractérisé en ce que l'épaisseur du film intercalaire (3) est égale à celle du guide de lumière (4).

4. Dispositif suivant l'une quelconque des revendications 1 à 3, caractérisé en ce que le film intercalaire (3) et le film protecteur (5) se composent du même matériau.

5. Dispositif suivant l'une quelconque des revendications 1 à 4, caractérisé en ce que le film intercalaire (3) est doublé d'un réflecteur (2), sur sa face opposée au film protecteur (5).

6. Dispositif suivant l'une quelconque des revendications 2 à 5, caractérisé en ce que le film protecteur (5), le film intercalaire (3) et le réflecteur (2) présentent des ouvertures coïncidentes (23 ; 33 ; 53) pour le passage d'éléments de commande, abstraction faite des ouvertures (22 ; 31, 32), prévues pour recevoir le guide de lumière (4).

Figur 1

Figur 2

Figur 3

Figur 4

EP 0 154 668 B1